Europäisches Patentamt

European Patent Office

Office européen des brevets

(19)

(11) Numéro de publication : **0 454 523 A1**

## (12) DEMANDE DE BREVET EUROPEEN

(21) Numéro de dépôt : **91400935.2**

(22) Date de dépôt : **08.04.91**

(51) Int. Cl.⁵ : **H03K 17/96**

(30) Priorité : 25.04.90 FR 9005260

(43) Date de publication de la demande :
**30.10.91 Bulletin 91/44**

(84) Etats contractants désignés :
**AT BE CH DE DK ES GB GR IT LI LU NL SE**

(71) Demandeur : **Société à Responsabilité
Limitée: DIGI-FRANCE
15C rue Le Corbusier, Europarc
F-94035 Creteil Cédex (FR)**

(72) Inventeur : **Carriere, Robert
121 Rue de Reuilly
F-75012 Paris (FR)**

(74) Mandataire : **Bonnetat, Christian
CABINET BONNETAT 23, Rue de Léningrad
F-75008 Paris (FR)**

(54) Dispositif de touche sensitive et clavier mettant en oeuvre un tel dispositif.

(57) — Dispositif de touche sensitive comportant une touche sensitive (1), un générateur à haute fréquence (19) alimentant ladite touche sensitive (1), des moyens de redressement (4) montés en dérivation sur ladite touche sensitive (1) et des moyens de comparaison (8) pour détecter la variation de niveau de la tension à la sortie desdits moyens de redressement (4).
— Selon l'invention, ce dispositif est remarquable en ce que la sortie desdits moyens de redressement (4) est reliée aux deux entrées desdits moyens de comparaison (8), d'une part par une première liaison directe (9), d'autre part par une seconde liaison comportant un condensateur de stockage (12).

EP 0 454 523 A1

La présente invention concerne un dispositif de touche sensitive et un clavier mettant en oeuvre un tel dispositif.

Le dispositif de touche et le clavier selon l'invention sont du type entièrement électronique et ne comportent aucune pièce mécanique, mis à part bien entendu le support des composants électroniques et le boîtier enfermant ceux-ci.

Plus particulièrement, l'invention se rapporte à un dispositif de touche sensitive destiné à être alimenté par un générateur à haute fréquence et comportant des moyens de redressement montés en dérivation sur une touche sensitive et des moyens de comparaison pour détecter la variation de niveau de la tension à la sortie desdits moyens de redressement.

Ainsi, lesdits moyens de comparaison surveillent en permanence la tension à la sortie desdits moyens de redressement. Lorsqu'une personne contacte ladite touche, elle fait office d'antenne pour l'énergie à haute fréquence émise par ledit générateur, de sorte que la tension redressée à la sortie desdits moyens de redressement diminue par rapport à ce qu'elle est lorsque personne ne contacte ladite touche. Les moyens de comparaison détectent cette baisse de la tension redressée et délivrent un signal caractéristique.

On voit que la sortie desdits moyens de comparaison présente deux états, respectivement caractéristiques de l'activation et de la non activation de ladite touche.

Dans les dispositifs connus de ce type, on prévoit une référence continue fixe à laquelle lesdits moyens de comparaison comparent la tension à la sortie desdits moyens de redressement.

Une telle disposition présente des inconvénients. En effet, lorsque la touche sensitive est disposée derrière une couche diélectrique épaisse (par exemple une couche de verre de deux à trois centimètres d'épaisseur), il est nécessaire que ladite touche sensitive soit très sensible ; mais alors celle-ci devient également sensible à son environnement immédiat, de sorte qu'il en résulte des fonctionnements intempestifs.

La présente invention a pour objet de remédier à ces inconvénients.

A cette fin, selon l'invention, le dispositif de touche sensitive comportant une touche sensitive, un générateur à haute fréquence alimentant ladite touche sensitive, des moyens de redressement montés en dérivation sur ladite touche sensitive et des moyens de comparaison pour détecter la variation de niveau de la tension à la sortie desdits moyens de redressement, est remarquable en ce que la sortie desdits moyens de redressement est reliée aux deux entrées desdits moyens de comparaison, d'une part par une première liaison directe, d'autre part par une seconde liaison comportant un condensateur de stockage.

Ainsi, lorsque la touche sensitive est contactée, la tension appliquée auxdits moyens de comparaison par ladite première liaison décroît instantanément, tandis que la tension appliquée auxdits moyens de comparaison par ladite seconde liaison se maintient momentanément à son niveau initial, grâce audit condensateur de stockage. On voit que la tension de référence appliquée aux moyens de comparaison, c'est-à-dire la tension délivrée par ladite seconde liaison, a un niveau initial comparable à celui de la tension détectée (celle de la première liaison). Lesdits moyens de comparaison sont donc soumis à une tension de référence flottante, fonction de la tension détectée par la touche sensitive, de sorte que le dispositif devient insensible à son environnement, malgré l'extrême sensibilité de la touche sensible.

De préférence, on fixe au repos la tension de référence à un niveau inférieur à celui de la tension de la touche sensitive et, à cet effet, ladite seconde liaison comportant un condensateur de stockage comporte de plus un moyen permettant d'imposer une différence de tension entre lesdites première et seconde liaisons. Un tel moyen permettant d'imposer une différence de tension entre lesdites première et seconde liaisons peut être une diode.

Ainsi, au repos, la tension de référence (seconde liaison) est inférieure à la tension redressée de la touche sensitive (première liaison). En revanche, en fonctionnement, la tension redressée de la touche sensitive devient immédiatement inférieure à la tension de référence. Lesdits moyens de comparaison détectent donc cette inversion de niveau des deux tensions qui sont appliquées sur ces deux entrées.

Afin d'obtenir une grande sensibilité pour la touche sensitive, il est avantageux qu'un amplificateur soit prévu entre ledit générateur à haute fréquence et ladite touche sensitive.

De préférence, ledit amplificateur comporte un transformateur élévateur et un transistor, le trajet émetteur-collecteur dudit transistor étant disposé en série dans le primaire dudit transformateur, tandis que la base dudit transistor est reliée à la sortie dudit oscillateur et que le secondaire dudit transformateur est relié à ladite touche sensitive.

Pour pouvoir régler le niveau de la haute fréquence, un potentiomètre est avantageusement monté dans le trajet émetteur-collecteur dudit transistor.

Par ailleurs, un condensateur est monté en parallèle sur le secondaire dudit transformateur et un noyau mobile est prévu entre lesdits primaire et secondaire dudit transformateur. On peut ainsi régler la résonance du circuit résonnant formé par ledit secondaire et ledit condensateur, et donc la sensibilité de ladite touche sensible.

Afin d'obtenir un clavier conforme à l'invention comportant une pluralité de touches sensitives, on peut prévoir un unique générateur à haute fréquence alimentant lesdites touches en parallèle, par l'intermédiaire d'un amplificateur unique.

De préférence, lesdits moyens de comparaison sont formés par un comparateur. On évite ainsi la formation de rebonds dans le signal de comparaison et on obtient une mise en forme avantageuse de ce dernier signal.

Bien entendu, la sortie desdits moyens de comparaison alimente une sortie d'utilisation, sur laquelle apparaît un signal de commande. De plus, la ou les sorties desdits moyens de comparaison peuvent être reliées à un voyant lumineux et/ou à un dispositif sonore pour avertir l'opérateur du bon fonctionnement de la ou des touches utilisées.

La figure unique du dessin annexé fera bien comprendre comment l'invention peut être réalisée.

Cette figure représente le schéma synoptique d'un clavier électronique, pourvu d'une pluralité de touches sensitives et conforme à la présente invention.

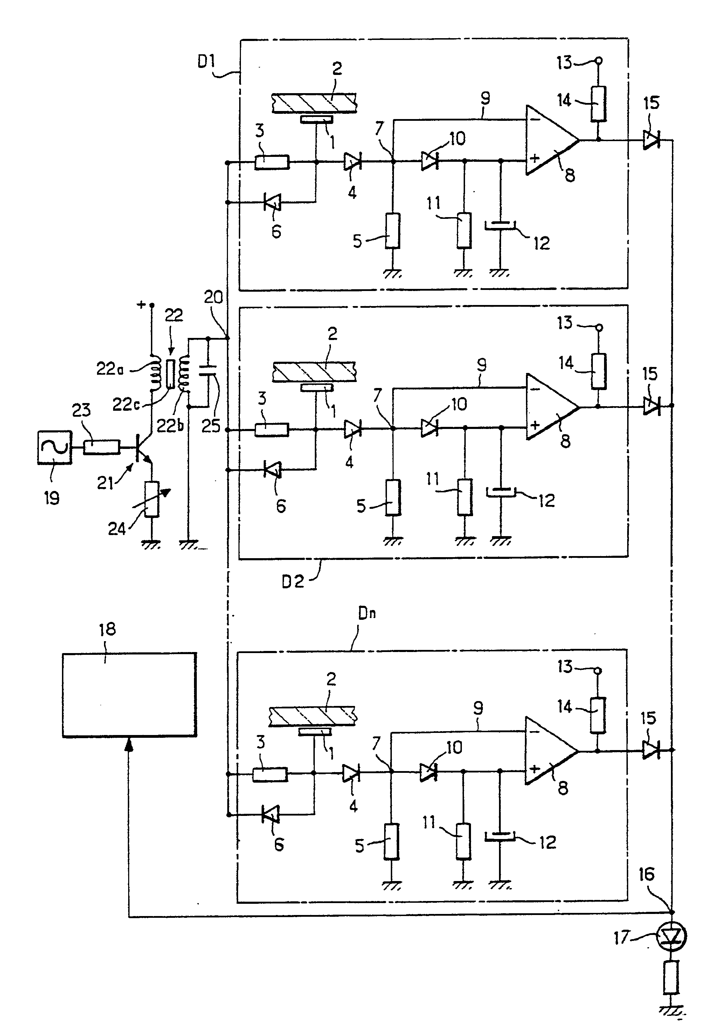

Le clavier électronique, conforme à l'invention et montré par la figure 1, comporte une pluralité de n dispositifs $D_1$, $D_2$, ..., Di...Dn montés en parallèle les uns sur les autres.

Chaque dispositif Di comporte une touche sensitive 1, disposée sous une épaisse couche de verre 2 et reliée, d'une part à une résistance de liaison extérieure 3 et, d'autre part, par une diode 4, à une résistance 5 de fixation de potentiel. Une diode anti-retour 6 est montée en parallèle sur la résistance de liaison extérieure 3. Le point 7 commun à la diode 4 et à la résistance 5 est relié aux entrées d'un comparateur 8 (à seuil de référence variable), d'une part par une liaison directe 9 et, d'autre part, par l'intermédiaire d'une diode 10 et d'un intégrateur constitué d'une résistance 11 et d'un condensateur 12 en parallèle. La sortie du comparateur 8 est reliée, d'une part à une borne d'utilisation 13 par une résistance 14 et, d'autre part, par une diode 15, à un point extérieur 16, commun à tous les dispositifs Di.

Une diode électro-luminescente 17 et un bruiteur 18 sont reliés audit point 16 extérieur aux dispositifs Di et sont communs à ceux-ci. Le bruiteur 18 est par exemple constitué par un oscillateur à basse fréquence (buzzer).

Par ailleurs, le clavier électronique comporte un oscillateur à haute fréquence 19, dont la sortie est reliée à un point 20, auquel sont reliés toutes les résistances 3. La fréquence de sortie de l'oscillateur est de quelques centaines de KHz, par exemple 800 KHz. Entre la sortie dudit oscillateur 19 et ledit point 20 est prévu un amplificateur constitué par un transistor amplificateur 21 et un transformateur élévateur 22. La sortie de l'oscillateur 19 est reliée à la base du transistor 21 par une résistance 23, le primaire 22a du transformateur 22 étant monté en série dans le trajet émetteur-collecteur dudit transistor. De plus, dans ce dernier trajet est monté un potentiomètre 24 de réglage de niveau de haute fréquence. Le secondaire 22b du transformateur 22, sur lequel est monté en parallèle un condensateur 25, est relié audit point 20 et un noyau mobile 22c est prévu entre lesdits primaire et secondaire 22a,22b pour régler la résonance du circuit résonnant 22b,25.

Ainsi, l'oscillateur 19 alimente chaque touche 1 en énergie à haute fréquence. Il en résulte, grâce au redressement obtenu par la diode 4, un niveau continu haut sur les deux entrées du comparateur 8. Toutefois, à cause de la diode 10, l'entrée positive de celui-ci, qui est reliée au point 7 par l'intégrateur 11,12 est à un niveau un peu inférieur (par exemple de 0,5 V) à celui de l'entrée négative dudit comparateur 8 qui est reliée au point 7 par la liaison directe 9. Lorsque les deux entrées sont au niveau haut, il n'en résulte aucun signal sur la sortie 13, ni au point 16.

En revanche, si une personne effleure une touche 1 à travers la couche de verre 2, elle constitue antenne pour l'énergie à haute fréquence et dissipe celle-ci. Par suite, la tension redressée par la diode 4 et appliquée sur les entrées du comparateur 8 passe au niveau bas. La liaison directe 9 impose immédiatement ce niveau bas à l'entrée négative du comparateur. En revanche, le condensateur 12 de l'intégrateur 11, 12 maintient momentanément le niveau haut sur l'entrée positive du comparateur 8, grâce à l'énergie qu'il a préalablement emmagasinée.

A cause de cette inversion momentanée des niveaux d'entrée sur le comparateur 8, un signal d'utilisation apparaît sur la sortie 13 et au point 16. Par suite, la touche contactée entraîne l'émission d'un signal d'utilisation sur la sortie 13 correspondante, ainsi que l'illumination du voyant 17 (diode électroluminescente) et l'activation du bruiteur 18.

On voit ainsi que, grâce à l'invention, on obtient un clavier entièrement électronique, sans parties mécaniques mobiles.

On remarquera que le clavier selon l'invention peut aussi bien être alimenté par le secteur que par batteries, de sorte qu'il peut être utilisé même dans des emplacements non alimentés par le secteur.

## Revendications

1. Dispositif de touche sensitive comportant une touche sensitive (1), un générateur à haute fréquence (19) alimentant ladite touche sensitive (1), des moyens de redressement (4) montés en dérivation sur ladite touche sensitive (1) et des moyens de comparaison (8) pour détecter la variation de niveau de la tension à la sortie desdits moyens de redressement (4),
caractérisé en ce que la sortie desdits moyens de redressement (4) est reliée aux deux entrées desdits moyens de comparaison (8), d'une part par une première liaison directe (9), d'autre part par une seconde liaison comportant un condensateur de stockage (12).

2. Dispositif de touche sensitive selon la revendication 1,
caractérisé en ce que ladite seconde liaison comportant un condensateur de stockage (12) comporte de plus un moyen (10) permettant d'imposer une différence de tension entre lesdites première et seconde liaisons.

3. Dispositif de touche sensitive selon la revendication 2,
caractérisé en ce que ledit moyen permettant d'imposer une différence de tension entre lesdites première et seconde liaisons est une diode (10).

4. Dispositif de touche sensitive selon l'une quelconque des revendications 1 à 3,
caractérisé en ce qu'un amplificateur (21,22) est prévu entre ledit générateur à haute fréquence (19) et ladite touche sensitive (1).

5. Dispositif de touche sensitive selon la revendication 4,
caractérisé en ce que ledit amplificateur comporte un transformateur élévateur (22) et un transistor (21), le trajet émetteur-collecteur dudit transistor étant disposé en série dans le primaire (22a) dudit transformateur, tandis que la base dudit transistor est reliée à la sortie dudit oscillateur (19) et que le secondaire (22b) dudit transformateur est relié à ladite touche sensitive (1).

6. Dispositif de touche sensitive selon la revendication 5,
caractérisé en ce qu'un potentiomètre (24) est monté dans le trajet émetteur-collecteur dudit transistor (21).

7. Dispositif de touche sensitive selon l'une quelconque des revendications 5 ou 6,
caractérisé en ce qu'un condensateur (25) est monté en parallèle sur le secondaire (22b) dudit transformateur (22) et en ce qu'un noyau mobile (22c) est prévu entre lesdits primaire (22a) et secondaire (22b) dudit transformateur (22).

8. Dispositif de touche sensitive selon l'une quelconque des revendications 1 à 7,
caractérisé en ce que lesdits moyens de comparaison sont formés par un comparateur (8).

9. Clavier comportant une pluralité de dispositifs de touches sensitives tels que spécifiés sous l'une quelconque des revendications 4 à 8,
caractérisé en ce qu'il comporte un unique générateur à haute fréquence (19) alimentant lesdites touches (1) en parallèle, par l'intermédiaire d'un amplificateur (21,22) unique.

Office européen
des brevets

**RAPPORT DE RECHERCHE EUROPEENNE**

Numero de la demande

EP   91 40 0935

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int. Cl.5) |
|---|---|---|---|
| Y | FR-A-2 596 542  (DIGI-FRANCE)<br>* figure 1; abrégé *<br>--- | 1,2,4,5,8,9 | H 03 K   17/96 |
| Y | PATENT ABSTRACTS OF JAPAN vol. 9, no. 50 (P-339)(1773), 5 mars 1985; & JP - A - 59188565 (RICOH K.K.) 25.10.1984<br>* figure; repères 5-9 *<br>--- | 1,2,4,5,8,9 | |
| A | EP-A-0 052 685  (STARCOTE LTD.)<br>* figure 3; abrégé *<br>--- | 1 | |
| A | DE-B-2 339 746  (SIEMENS AG)<br>* figure; revendication 1 *<br>--- | 1 | |
| A | DD-A- 129 950  (J. HAUPT)<br>* figure 4; page 6, lignes 4-13 *<br>--- | 1 | |
| A | EP-A-0 190 645  (HORIBA, LTD.)<br>* figure 2; page 3, ligne 15 - page 4, ligne 19; revendication 2 *<br>----- | 1,2 | |

DOMAINES TECHNIQUES RECHERCHES (Int. Cl.5)

G 01 R   19/165
G 08 B   13/26
H 03 K    3/00
H 03 K   17/30
H 03 K   17/96
H 03 K   17/975
H 03 K   17/98

Le présent rapport a été établi pour toutes les revendications

| Lieu de la recherche | Date d'achèvement de la recherche | Examinateur |
|---|---|---|
| BERLIN | 12-06-1991 | ARENDT M |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons

....................................................................
& : membre de la même famille, document correspondant

EPO FORM 1503 03.82 (P0402)